# DEMANDE DE BREVET EUROPEEN

(11) **EP 1 178 294 A1**
(43) Date de publication de la demande: **06.02.2002**
(21) Numéro de dépôt: 00116867.3
(22) Date de dépôt: 04.08.2000
(51) Int. Cl.: G01J 5/34, H01L 37/02

(54) **Capteur pyroélectrique ayant entre ses pixels un couplage thermique parasite réduit**

(71) Demandeur: ECOLE POLYTECHNIQUE FEDERALE DE LAUSANNE, 1015 Lausanne (CH)
(72) Inventeur: Seifert, Andreas, 1025 St-Sulpice (CH); Murait, Paul, 1315 La Sarraz (CH)
(74) Mandataire: Surmely, Gérard

(57) **Abrégé**

Le capteur pyroélectrique comprend une pluralité de pixels (12A,12B) formés chacun d'une couche pyroélectrique mince (20A,20) et de première et seconde électrodes (14,28) agencées de part et d'autre de cette couche. Les électrodes inférieures (28) sont structurées, c'est à dire qu'elles sont micro-usinées de manière à former des électrodes propres aux pixels de manière à réduire le couplage thermique parasite entre les pixels. De manière avantageuse, la couche pyroélectrique est poreuse. Selon un mode de réalisation préféré de l'invention, la couche pyroélectrique poreuse (20A) est traversante et déposée uniformément sur le substrat du capteur. Les couches poreuses présentent une conductivité thermique réduite permettant d'obtenir des capteurs avec une bonne résolution sans nécessiter un micro-usinage de la couche pyroélectrique entre les pixels. Pour isoler thermiquement les pixels (12A) du substrat (8A) on forme une couche à aerogel (32) et une couche de nivellement (34).

## Description

La présente invention concerne un capteur pyroélectrique comprenant une pluralité de pixels agencés sur un substrat et formé chacun d'une couche pyroélectrique mince, d'une première électrode propre définissant géométriquement le pixel et d'une seconde électrode, ces première et seconde électrodes étant agencées respectivement des deux côtés de la couche pyroélectrique.

La technologie des capteurs pyroélectriques fabriqués en lot sur un support notamment en silicium avec une couche pyroélectrique mince déposée par des méthodes similaires à celle de la technologie des semi-conducteurs est relativement récente. Une telle technologie permet d'obtenir des capteurs pyroélectriques relativement bon marché pouvant être fabriqués en grande quantité de manière industrielle. Ces capteurs peuvent être utilisés notamment pour la spectrométrie des gaz ou l'imagerie thermique.

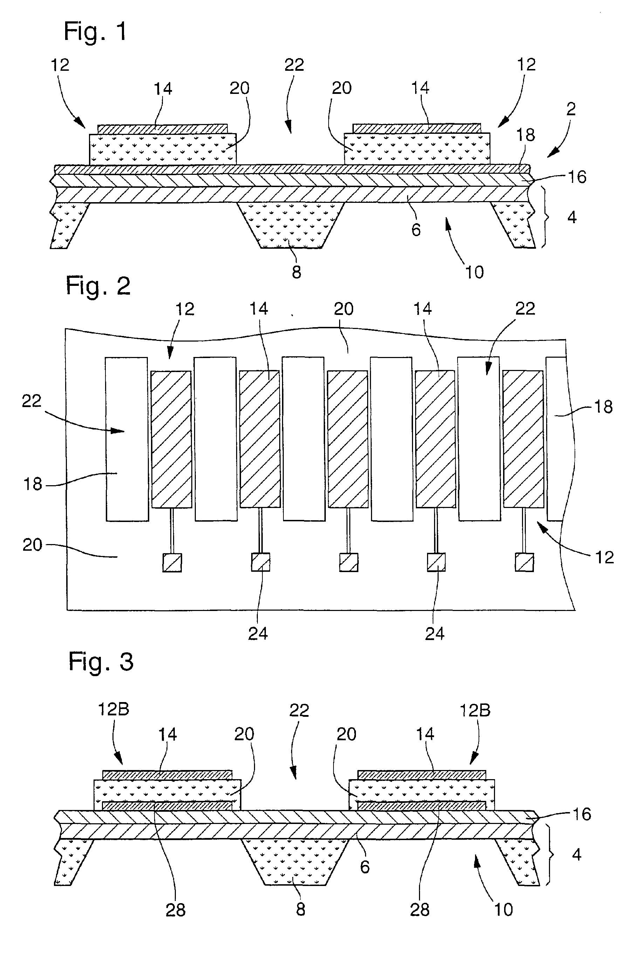

Dans les premiers développements de ces capteurs, l'homme du métier a cherché à minimiser les coûts de production tout en assurant une bonne qualité des capteurs fabriqués. Un facteur intervenant dans l'efficacité du capteur concerne le couplage thermique parasite entre les pixels, plus particulièrement entre des pixels adjacents. Pour atteindre le double objective mentionné ci-avant, des capteurs tels que représentés aux figures 1 et 2 ont été réalisés initialement notamment par la Demanderesse. La figure 1 représente en coupe deux pixels d'un capteur formé d'un réseau linéaire de pixels tels que représentés en vue de dessus à la figure 2.

Le capteur 2 est formé d'un substrat 4 présentant une membrane supérieure 6 de faible épaisseur et une plaque de base en silicium 8 dans laquelle sont micro-usinés des évidements 10 au moins au-dessous des pixels 12 définis par les électrodes supérieures propres 14. Sur la membrane 6 est formée une couche d'adhésion 16 à la surface supérieure de laquelle est déposée une électrode inférieure 18 commune aux pixels. Afin d'éviter une étape de micro-usinage de la couche conductrice 18, il est prévu que celle-ci soit traversante sur l'ensemble de la surface du capteur 2. Entre l'électrode commune 18 et les électrodes propres 14 est déposée une couche pyroélectrique mince 20. Cette couche 20 est micro-usinée de manière à isoler thermiquement les pixels entre-eux. Des évidements 22 sont ainsi formés entre les pixels du réseaux linéaire, ces évidements présentant dans une vue de dessus un profil rectangulaire. On notera que les électrodes 14 sont reliées à des plages de contact 24 permettant de fournir des signaux électriques élémentaires.

Un premier but de la présente invention est de réduire le couplage thermique parasite entre les pixels. Un deuxième but de l'invention est de diminuer les coûts de production de capteurs pyroélectriques en couches minces. Un troisième objet de l'invention consiste à trouver un optimum entre les deux buts susmentionnés, c'est-à-dire d'obtenir un capteur présentant une bonne résolution au niveau des pixels et un prix de fabrication relativement bas.

Le premier but susmentionné est atteint par l'objet selon la revendication 1. Les autres buts sont atteints par les objets des revendications secondaires, en particulier les revendications 2, 4 et 6.

Ces objets ainsi que leurs avantages respectifs seront décrits ci-après à l'aide de la description suivante, faite en référence au dessin annexé donné à titre d'exemples nullement limitatifs, dans lequel :
- les figures 1 et 2, déjà décrites, sont des vues partielles, respectivement en coupe et de dessus d'un capteur pyroélectrique initialement développé par la Demanderesse;
- la figure 3 est une vue en coupe d'un premier mode de réalisation d'un capteur selon l'invention;
- les figures 4 et 5 sont des vues partielles respectivement en coupe et de dessus d'un deuxième mode de réalisation d'un capteur selon l'invention.

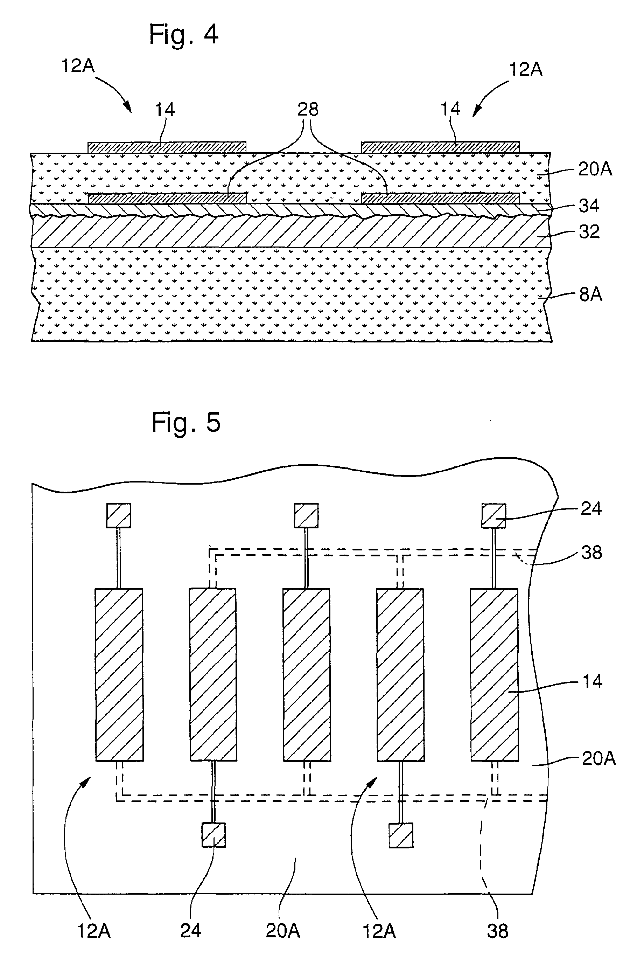

Les inventeurs ont observé que l'électrode inférieure 18 commune aux pixels du capteur 2 représenté aux figures 1 et 2, bien que de faible épaisseur, engendre un couplage thermique parasite (en anglais: thermal cross-talk) non négligeable. Pour supprimer cet inconvénient mis en lumière par leur recherche, les inventeurs ont perfectionné le capteur décrit aux figures 1 et 2 en structurant également l'électrode inférieure; c'est-à-dire en formant des électrodes inférieures propres aux pixels. Il est prévu que chacune de ces électrodes inférieures ne présentent aucune liaison métallique avec les autres électrodes inférieures du capteur ou qu'elles soient reliées avec celles-ci seulement par des pistes métalliques de section relativement petite et de préférence relativement longue, comme cela est le cas pour le capteur représenté à la figure 5 qui sera décrit par la suite. Par section relativement petite, on comprend une section largement inférieure à la section des électrodes d'un pixel selon une direction perpendiculaire à la direction longitudinale définie par une rangée de pixels telle que représentée aux figures 2 et 5. Un capteur selon le mode de réalisation décrit ici est représenté partiellement en coupe à la figure 3 où les pixels 12B ont des électrodes inférieures 28 situées en regard des électrodes supérieures 14 et présentant des dimensions sensiblement égales à ces dernières. Les références déjà décrites ne le sont pas à nouveau ici.

Dans le cadre de leur recherche, les inventeurs ont déposé des couches pyroélectriques poreuses dans le but de diminuer la permittivité électrique des pixels et d'augmenter ainsi leur efficacité. Les résultats de cette analyse sont publiés notamment dans les deux articles suivants:
- "High figure ― of ― merit porose Pb ₁₋ₓ CaₓTiO₃ thin films for pyroelectric applications", A. Seifert & all, Applied Physics Letters, vol. 72, No 19, May 1998;
- "Microstructural evolution of dense and pores pyroelectric Pb ₁₋ₓCaₓTiO₃ thin films", A. Seifert & all, Journal of Materials Research, vol. 14, No 5, May 1999.

Le procédé de croissance décrit dans ces documents consiste en un dépôt par croissance spécifique des couches poreuses. De tels dépôts sont lents et donc relativement onéreux. De plus ils se limitent à un nombre restreint de matériaux pouvant être déposés ainsi sous forme poreuse.

L'utilisation de couches poreuses minces pour la couche pyroélectrique s'est montrée particulièrement avantageuse pour les performances du capteur ainsi fabriqué. Dans le cadre de la présente invention, il a été observé que de telles couches poreuses présentent une conductivité thermique restreinte relativement aux couches denses déposées précédemment. D'un autre côté, le micro-usinage de telles couches s'avèrent une opération délicate étant donné la difficulté d'une attaque chimique pour de telles couches poreuses. Dans le cadre des recherches liées aux couches pyroélectriques poreuses, les inventeurs ont analysé le comportement d'un capteur tel que représenté aux figures 4 et 5 qui présente une couche pyroélectrique poreuse traversante et uniforme, c'est-à-dire non micro-usinée pour obtenir des évidements comme prévus à la figure 2. Les résultats des tests effectués ont montré qu'un tel capteur présente une bonne résolution au niveau des pixels, c'est-à-dire que le couplage thermique parasite entre les pixels est relativement bas. Le niveau de ce couplage thermique parasite est maintenu à une valeur tout à fait correcte étant donné qu'il a été prévu de structurer les électrodes inférieures et supérieures comme décrit précédemment dans le premier mode de réalisation de l'invention.

Le fait de prévoir une couche pyroélectrique non structurée pour un capteur permet de réduire le prix de revient du capteur en éliminant des étapes de fabrication et en particulier l'étape difficile à réaliser mentionnée ci-dessus. Le capteur présenté aux figures 4 et 5 est formé d'un support en silicium ne présentant pas de cavités micro-usinées comme dans les modes décrits précédemment. A la surface supérieure du substrat est formée une couche à aérogel 32 sur laquelle est déposée une couche de nivellement 34 étant donné que la couche aérogel présente une certaine rugosité. Sur la couche 34 sont déposées les électrodes inférieures 28 de manière similaire à la réalisation de la figure 3. Ensuite, le capteur comprend une couche pyroélectrique poreuse 20A traversante, c'est-à-dire commune à l'ensemble des pixels et non micro-usinée entre ces pixels. Finalement sur cette couche 20A sont déposées les électrodes supérieures 14. Le mode de réalisation de la figure 4 est particulièrement avantageux par le fait qu'il est formé essentiellement de couches traversantes ne nécessitant pas de micro-usinage particulier. En effet, seules les électrodes inférieures et supérieures avec leurs pistes conductrices et les plages de contact prévues sont structurées et nécessitent donc un micro-usinage par photolithographie et une attaque chimique ou sèche. La couche aérogel a comme propriété d'isoler thermiquement les pixels 12A du substrat 8A. L'utilisation de telles couches d'aérogel est décrit notamment dans le brevet américain US 5,949,071.

Les électrodes supérieures 14 sont reliées à des plages de contact individuelles 24, lesquelles sont agencées alternativement d'un côté et de l'autre de la rangée de pixels. Les électrodes inférieures 28 sont reliées entre-elles au moyen de pistes conductrices 38, représentées en tirets à la figure 5. Ces pistes présentent une section relativement petite et, vu leur agencement, quasi aucun couplage thermique parasite entre les pixels.

Finalement, dans le cadre des recherches et développements décrits ici, les inventeurs ont utilisés une méthode de dépôt de la couche pyroélectrique poreuse bien plus avantageuse que celle décrit dans les documents cités ci-avant où le dépôt est effectué par une croissance de la couche lente, onéreuse et réduite pour les matériaux utilisables. C'est ainsi qu'ils ont mis au point le dépôt d'une couche pyroélectrique poreuse par un dépôt chimique en phase liquide en incorporant au moins un polymère soluble dans la solution de base. Un tel procédé de dépôt décrit ci-après permet de diminuer fortement le prix de revient des capteurs. Le procédé de dépôt chimique en phase liquide utilisé pour l'application aux capteurs pyroélectriques comprend, dans une variante de mise en oeuvre, les étapes suivantes:
- Synthèse d'une solution sol-gel ayant comme base des alcoxydes avec une molarité d'environ 0.4;
- Dissolution de di-hydroxy polyéthylène oxyde polymère dans la solution alcoxyde, notamment entre 1.5 et 10 % par unité de poids;
- Dépôt d'une couche sur le substrat et les électrodes inférieures à partir de la solution alcoxyde contenant le polymère dissout par centrifugation (en anglais: spin-coating) notamment à 3000 tours par minute pendant environ 40 secondes;
- Premier traitement thermique à environ 350° C pour décomposer le contenu organique de la solution alcoxyde et éliminer le polymère;
- Deuxième traitement thermique entre environ 650° C et 700° C pour transformer la couche d'alcoxyde pyrolisée dans une céramique pyroélectrique et pour augmenter la porosité obtenue précédemment par l'élimination du polymère.

Les deux dernières étapes peuvent être répétées plusieurs fois de manière à obtenir une couche plus épaisse. Le poids moléculaire du polymère dissout dans la solution de base est prévu entre 1000 et 4600 pour obtenir la porosité désirée. Le premier traitement thermique permet donc par élimination du polymère d'obtenir une porosité, laquelle peut être augmentée lors du deuxième traitement thermique. La porosité par unité de volume est située environ entre 15 et 35 %.

On notera que le dépôt sur la plaquette en fabrication peut être effectué non seulement par centrifugation, mais aussi par d'autres techniques connues de l'homme du métier, notamment par immersion (anglais: dip-coating) ou par projection (anglais: spray-coating). On obtient ainsi une couche pyroélectrique poreuse recouvrant uniformément le substrat et les électrodes inférieures au moins dans la région définie part la pluralité de pixels formant le capteur selon l'invention.

L'homme du métier, sur la base de l'enseignement donné ici, pourra mettre au point des procédés de dépôts similaires en utilisant d'autres solutions de base et d'autres polymères pour obtenir un résultat équivalent ou similaire à celui exposé ici.

## Revendications

1. Capteur pyroélectrique comportant une pluralité de pixels (12A; 12B) agencés sur un substrat (4) et formés chacun d'une couche pyroélectrique mince (20; 20A), d'une première électrode propre (14 ; 8A) agencée à une face de cette couche et d'une seconde électrode (28) agencée à l'autre face, **caractérisé en ce que** ladite seconde électrode de chaque pixel définit également une électrode propre à ce pixel, cette seconde électrode n'ayant pas de liaison métallique avec d'autres secondes électrodes ou étant reliées à celles-ci seulement par des pistes métalliques de sections relativement petites.

2. Capteur selon la revendication 1, **caractérisé en ce que** ladite couche pyroélectrique est poreuse et **en ce que** cette couche (20A) est traversante entre les pixels d'un même capteur.

3. Capteur selon la revendication 2, **caractérisé en ce que** ladite couche pyroélectrique recouvre uniformément ledit substrat au moins dans la région définie par ladite pluralité de pixels.

4. Capteur selon la revendication 2 ou 3, **caractérisé en ce que** ledit substrat n'est pas micro-usiné et présente une couche intermédiaire (32) avec les pixels formée d'un aérogel formant un isolant thermique entre ces pixels et le substrat.

5. Capteur selon la revendication 4, **caractérisé en ce que** ladite couche intermédiaire est recouverte d'une couche de nivellement.

6. Capteur selon l'une des revendications 2 à 5, **caractérisé en ce que** la dite couche pyroélectrique poreuse est déposée par un procédé sol-gel avec introduction d'un polymère soluble dans la solution de base, ce polymère étant éliminé ultérieurement au dépôt de la couche lors d'au moins un traitement thermique.

7. Capteur selon la revendication 6, **caractérisé en ce que** ladite solution est une solution alcoxyde et ledit polymère est du di-hydroxy polyéthylène oxyde dont le poids moléculaire et situé entre 1'000 et 4'600.

8. Capteur selon l'une des revendications 2 à 7, **caractérisé en ce que** le volume des pores par unité de volume de la couche pyroélectrique est situé environ entre 15 et 35%.
